# EUROPÄISCHE PATENTSCHRIFT

(11) **EP 0 782 746 B1**
(45) Veröffentlichungstag und Bekanntmachung des Hinweises auf die Patenterteilung: **10.06.1998**
(21) Anmeldenummer: 95931157.2
(22) Anmeldetag: 20.09.1995
(51) Int. Cl.: G11C 8/04

(54) **SPEICHEREINRICHTUNG UND VERFAHREN ZUM GLEICHZEITIGEN LESEN UND SCHREIBEN VON DATEN**
STORAGE DEVICE AND PROCESS FOR SIMULTANEOUSLY READING AND RECORDING DATA
DISPOSITIF DE MEMORISATION ET PROCEDE DE LECTURE ET D'ENREGISTREMENT SIMULTANES DE DONNEES

(30) Priorität: 23.09.1994 DE 4434107
(43) Veröffentlichungstag der Anmeldung: 09.07.1997
(73) Patentinhaber: Océ Printing Systems GmbH, 85586 Poing (DE)
(72) Erfinder: BAUMGARTNER, Robert, D-85457 Wörth (DE); GRÖGER, Hans-Detlef, D-85551 Kirchheim (DE)
(74) Vertreter: Schaumburg, Thoenes, Thurn Patentanwälte
(86) Internationale Anmeldenummer: DE9501294
(87) Internationale Veröffentlichungsnummer: WO9609627

(56) Entgegenhaltungen:
- EP-A- 0 155 731
- EP-A- 0 306 726
- EP-A- 0 447 266
- US-A- 4 171 538
- US-A- 4 809 156
- PATENT ABSTRACTS OF JAPAN vol. 8 no. 60 (P-262) ,22.März 1984 & JP,A,58 208905 (SONY KK) 5.Dezember 1983,
- PATENT ABSTRACTS OF JAPAN vol. 18 no. 113 (E-1514) ,23.Februar 1994 & JP,A,05 308544 (MATSUSHITA ELECTRIC) 19.November 1993,
- PATENT ABSTRACTS OF JAPAN vol. 14 no. 76 (P-1005) ,13.Februar 1990 & JP,A,01 291321 (MITSUBISHI ELECTRIC) 22.November 1989,

## Beschreibung

Die Erfindung betrifft eine Speichereinrichtung und ein Verfahren zum gleichzeitigen Lesen- und Schreiben von Daten. Erfindungsgemäße Speichereinrichtungen werden beispielsweise bei der Komprimierung und Dekomprimierung von Bildinformationen benötigt. Ein Bild, das beispielsweise eine Grafik, einen Text oder ähnliches beinhaltet, besteht aus einer Mehrzahl einzelner Bildpunkte, sogenannter Pixel, die matrixartig angeordnet sind. Jede Zeile dieser Matrix enthält eine Anzahl von Bildpunkten, die entweder den Wert "weiß" oder "schwarz" repräsentieren. Diese Pixel können durch einen Bildschirm, einen Drucker oder ein anderes Bildwiedergabegerät sichtbar gemacht werden. Zum Transportieren oder Speichern eines Bildes wird die Bildinformation komprimiert. Die komprimierten Bildinformationen können dekomprimiert und wieder sichtbar gemacht werden.

Solche Komprimierungs- und Dekomprimierungsverfahren sind aus der Faksimiletechnik bekannt und beispielsweise im CCITT, "The International Telegraph Consultative Committee" , Blue Book, Vol. VII-Facsimile VII.3, Recommendations T.0 - T.63, beschrieben. Außer diesen vom CCITT festgelegten Komprimierungs- und Dekomprimierungsvorschriften, werden auch andere Komprimierungs- und Dekomprimierungsvorschriften ,wie z.B. von HP (Hewlett Packard) verwendet. Bei diesen gebräuchlichen Vorschriften werden Algorithmen angewendet, die nicht nur die Informationen innerhalb einer Zeile (z.B. Huffman Encoding) miteinander verknüpfen, sondern auch solche, die eine Verknüpfung der Bildinformationen zweier aufeinanderfolgender Zeilen durchführen. Um eine solche Verknüpfung vorzunehmen, wird eine Verarbeitungseinheit, die die Verknüpfungsoperation durchführt benötigt. Dieser Verarbeitungseinheit muß auch eine Speichereinrichtung zugeordnet sein, aus der stets ein gerade benötigtes Pixel einer Referenzzeile auslesbar und ein erzeugtes Pixel einer aktuellen Zeile einschreibbar sein muß.

Aus EP 0 341 272 B1, ist eine Dekodierungseinrichtung bekannt, die aus nach CCITT kodierten Bildinformationen Pixel erzeugt. Eine Verarbeitungseinrichtung arbeitet dazu mit einer Speichereinrichtung gemäß den Oberbegriff des Anspruchs 1 zusammen. Die Speichereinrichtung enthält zwei getrennte Speicher, von denen einer sämtliche Pixel der Referenzzeile enthält. In den anderen Speicher werden die während der Dekodierung erzeugten Pixel sequentiell nacheinander eingeschrieben. Ist die aktuelle Zeile vollständig dekodiert, dann liegen alle Pixel dieser Zeile im Speicher für die aktuelle Zeile. Die ehemalige Referenzzeile wird nicht mehr benötigt und die aktuelle Zeile soll bei der Dekodierung der nachfolgenden Zeile als Referenzzeile dienen. Deshalb werden die Speichereinträge des Speichers für die aktuelle Zeile in den Speicher für die Referenzzeile übertragen. Anschließend wird mit der Dekodierung der nächsten Zeile unter Verwendung der neuen Referenzzeile begonnen werden.

Beim Stand der Technik wird durch den Aufbau der Speichereinrichtung mittels zweier getrennter Speicher, die gleichzeitig auslesbar und beschreibbar sind, eine Erhöhung der Geschwindigkeit der Verarbeitungseinheit bei der Dekompression von Bilddaten erreicht. Aufgrund dieser Geschwindigkeitserhöhung besteht jedoch ein großer Bedarf an schnellen Speichern. Dieser hohe Speicherbedarf verbraucht eine verhältnismäßig große Halbleiterfläche. Eine solche ist jedoch in der Regel nicht verfügbar, da die Bildverarbeitungsvorrichtung in der Regel durch einen integrierten Schaltkreis in Form eines ASIC (Application Specific Integrated Circuit) realisiert wird. Mit diesen Bausteinen lassen sich hohe Anforderungen an die Verarbeitungsgeschwindigkeit befriedigen. Aufgrund der begrenzten zur Verfügung stehenden Fläche auf einem ASIC , muß die für die Speichereinrichtung benötigte Fläche auf ein Mindestmaß reduziert werden. Insbesondere können Speicherstrukturen eines Video-RAM's aufgrund ihres Flächenbedarfs bei aktueller Technik keinesfalls in ein ASIC implementiert werden. Eine Auslagerung der Speicher aus dem ASIC kann vorgenommen werden, ist aber in der Regel nicht erwünscht.

Aus US-A 49 87 559 ist eine Speichereinrichtung (Video-RAM) mit Schieberegistern zum seriellen Empfang von Daten und zum seriellen Abgeben von Daten bekannt. Die Daten werden jeweils parallel in einen Matrixspeicher übertragen, bzw. von diesem abgegeben. Eine wesentliche Grundlage für die Funktionsfähigkeit der bekannten Speichereinrichtung ist die an die Anzahl der Spalten des Matrixspeichers angepaßte Länge des Schieberegisters. Um ein gleichzeitiges Lesen und Schreiben von Daten zu ermöglichen werden zwei solche Schieberegister benötigt. Diese Tatsache steht einer Verwendung der bekannten Speichereinrichtung für die Minimierung der Fläche einer Speichereinrichtung entgegen.

Aus US-A-4171538 ist ein Baustein zur Taktanpassung bekannt. Dieser Schaltkreis setzt empfangene Daten, eines reproduzierten Taktes, in Daten mit einer Datenrate eines lokalen Taktes um. Dazu wird zu einem Zeitpunkt zwischen den auszulesenden Daten und den empfangenen Daten ein definierter Adreßabstand eingestellt. Durch inkrementieren der Adreßzähler mittels der beiden nicht-synchronen Takte kann es zu einer Adressenkollision kommen. Bei großen Taktunterschieden kommt es zu einem Datenverlust.

Aus EP-A2-0306726 ist ein integrierter Schaltkreis bekannt, mit dem Daten zwischengespeichert werden können. In diesem Speicherbaustein sind zwei Speicherarrays integriert. Durch einen wechselseitigen Zugriff auf jeweils einen der Arrays kann ein schneller Zugriff auf die Speicherplätze zum Lesen oder Schreiben erreicht werden. Die zu verarbeitende Information wird in zwei getrennten, auf einem Chip integrierten Speichern hinterlegt. Diese getrennte Speicheranordnung bringt zwar den Vorteil, daß ein schneller Zugriff ermöglicht wird, bedingt allerdings auch, daß ein hoher Flächenbedarf auf dem Halbleiter besteht.

Der vorliegenden Erfindung liegt die Aufgabe zugrunde, eine Speichereinrichtung und ein Verfahren zum gleichzeitigen Lesen und Schreiben von Daten aufzuzeigen, die insbesondere bei der Komprimierung und Dekomprimierung von Bildinformationen, insbesondere in einem ASIC-Bautein, eine hohe Verarbeitungsgeschwindigkeit bei minimalem Speicherbedarf ermöglichen.

Dise Aufgabe wird durch die in den Patentansprüchen 1 bzw. 6 angegebenen Merkmale gelöst. Ausgestaltungen und Weiterbildungen der Erfindung sind in den Unteransprüchen angegeben.

Die erfindungsgemäße Speichereinrichtung enthält, nur einen einzigen Speicher. Dieser Speicher benötigt nur eine geringfügig größere Kapazität als zur Aufnahme der Pixel einer vollständigen Zeile eines Bildes erforderlich ist. Die Speichereinrichtung erfüllt aufgrund ihrer gleichzeitigen Beschreibbarkeit und Auslesbarkeit die Anforderung, wonach gleichzeitig einzelne Pixel der Referenzzeile lesbar und erzeugte Pixel der aktuellen Zeile in die Speichereinrichtung schreibbar sein müssen. Dennoch ist der Flächenbedarf der Speichereinrichtung nur etwa halb so groß, wie bei bekannten Bildverarbeitugnsvorrichtung zur sequentiellen Kodierung und Dekodierung von Bildinformationen. Somit kann die Speichereinrichtung auf einem ASIC-Baustein untergebracht werden, auf dem nur Single-Port-RAM's oder Dual-Port-RAM's verfügbar sind, die mit begrenzter Bitbreite parallel beschreibbar und auslesbar sind. Serielle Daten werden innerhalb eines einzigen Taktes verarbeitet. Die Zuverlässigkeit der Speichereinrichtung ist besonders für die Anforderungen bei der Komprimierung und Dekomprimierung von Bildinformationen geeignet, bei der es sich um einen kontinuierlichen Vorgang handelt, der nicht aufgehalten werden kann.

Gemäß einer Weiterbildung und Ausgestaltung der Erfindung, weist die Speichereinrichtung eine Eingangsschnittstelle auf, die Pixel der aktuellen Zeile seriell aufnimmt und blockweise parallel abgibt. Eine Ausgangsschnittstelle nimmt die Pixel der Referenzzeile parallel aus dem Speicher auf und gibt sie seriell nach außen ab. Durch diese Serien- /Parallel- bzw. Parallel- /Serienwandlung, kann innerhalb der Speichereinrichtung ein Speicher verwendet werden, der wesentlich geringere Geschwindigkeitsanforderungen erfüllen muß, als ein die Pixel seriell aufnehmender und abgebender Speicher. Es wird zudem eine weitere Reduzierung der Speicherfläche dadurch erreicht, daß auf Grund der gewonnenen Zeit innerhalb der Speichereinrichtung ein gleichzeitiges Lesen und Schreiben nicht erforderlich ist. Zur Realisierung kann deshalb ein Single-Port-RAM (Random Access Memory) verwendet werden. Dieser benötigt weniger Speicherfläche als ein Dual-Port-RAM, der andernfalls verwendet werden müßte.

Weitere Ausgestaltungen und Weiterbildungen sind in den Unteransprüchen angegeben. Ein Ausführungsbeispiel der Erfindung wird im folgenden anhand der Zeichnung näher erläutert. Dabei zeigen
- Figur 1: ein Blockschaltbild Bildverarbeitungsvorrichtung mit einer erfindungsgemäßen Speichereinrichtung und einer Steuerungslogik,
- Figur 2: ein Blockschaltbild der erfindungsgemäßen Speichereinrichtung,
- Figur 3: ein Blockschaltbild der erfindungsgemäßen Adreßerzeugung innerhalb der Speichereinrichtung,
- Figur 4: ein Ablaufdiagramm des Verfahrensablaufs beim Schreiben und Lesen der Speichereinrichtung,
- Figur 5: ein Ablaufdiagramm des Unterprogramms zur Initialisierung der Speichereinrichtung,
- Figur 6: ein Ablaufdiagramm des Unterprogramms zum Schreiben von Daten in die Speichereinrichtung, und
- Figur 7: ein Ablaufdiagramm des Unterprogramms zum Lesen von Daten aus der Speichereinrichtung.

Das folgende Beispiel beschreibt eine Speichereinrichtung die in einer Bildverarbeitungsvorrichtung zur sequentiellen Dekodierung von Bildinformationen eingesetzt wird. Es versteht sich, daß die Speichereinrichtung in anderen Umgebungen, wie z.B. in einer Bildverarbeitungsvorrichtung zur sequentiellen Kodierung von Bildinformationen, die hier nicht beschrieben wird, in analoger Weise einsetzbar ist.

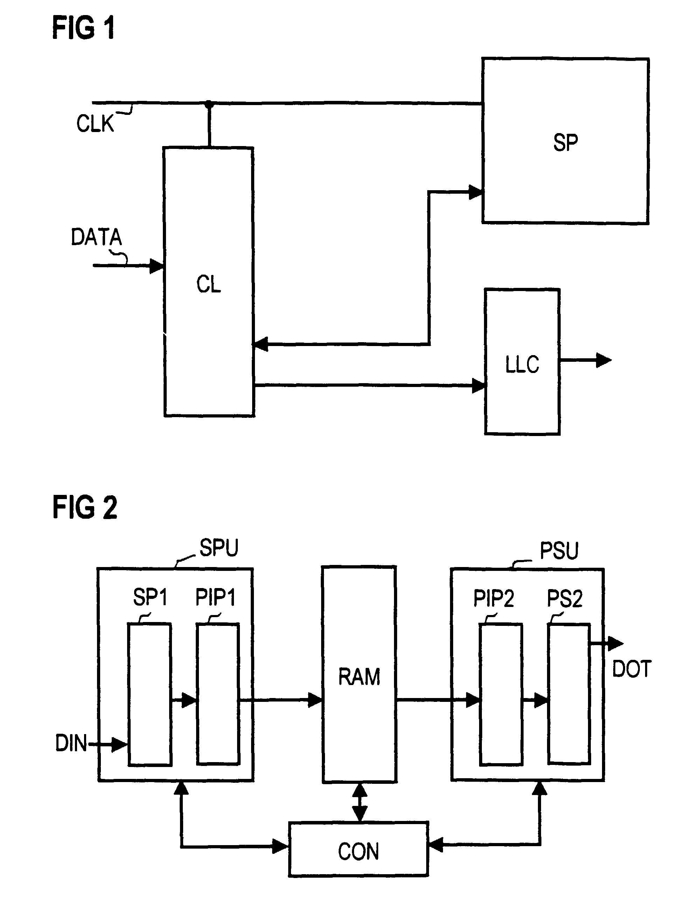

Eine Bildverarbeitungsvorrichtung ist, wie im Blockschaltbild von Figur 1 gezeigt, aufgebaut. Eine Steuerungslogik CL ist mit einer Speichereinrichtung SP gekoppelt. Komprimierte Daten DATA, werden an die Steuerungslogik CL übergeben. Nach der Dekodierung gibt die Steuerungslogik CL eine in Lauf langen- und Farbinformation getrennte Bildinformation an einen Lauflängenkodierer LLC aus, der aus den Lauf langen- und Farbinformationen die einzelnen Pixel zur Bildwiedergabe erzeugt. Um eine synchrone Arbeitsweise der Steuerungslogik CL und der Speichereinrichtung SP zu gewährleisten, wird diesen Komponenten ein gemeinsamer Takt CLK zugeführt.

Die Speichereinrichtung SP enthält, wie in Figur 2 gezeigt, eine Eingangsschnittstelle SPU, einen Speicher RAM und eine Ausgangsschnittstelle PSU, die miteinander gekoppelt sind. Die Eingangsschnittstelle SPU enthält einen Serien-/Parallelwandler SP1, in den Eingangsdaten DIN in Form einzelner Pixel seriell einschreibbar sind. Diesem Serien-/ Parallelwandler SP1 ist ein Pufferspeicher PIP1 nachgeschaltet. Seriell in dem Serien-/ Parallelwandler SP1 geschriebene Eingangsdaten DIN, können parallel in den Pufferspeicher PIP1 übernommen werden. Aus dem Pufferspeicher PIP1 werden die parallelen Eingangsdaten DIN parallel in den Speicher RAM geschrieben. Eine mit den Komponenten der Speichereinrichtung SP gekoppelte Speichersteuereinrichtung CON bestimmt dabei die Adresse des Speicherplatzes im Speicher RAM, an dem die Eingangsdaten DIN abgelegt werden. Diese Speichersteuereinrichtung CON bestimmt auch die Adresse der Ausgangsdaten DOT, die parallel an einen zweiten Pufferspeicher PIP2, der in der Ausgangsschnittstelle PSU enthalten ist, übergeben werden. Aus diesem zweiten Pufferspeicher PIP2, sind die Ausgangsdaten DOT in einen Parallel- /Serienwandler PS2 schreibbar. Dieser Parallel- /Serienwandler PS2 gibt die Ausgangsdaten DOT in Form einzelner Pixel seriell nach außen ab.

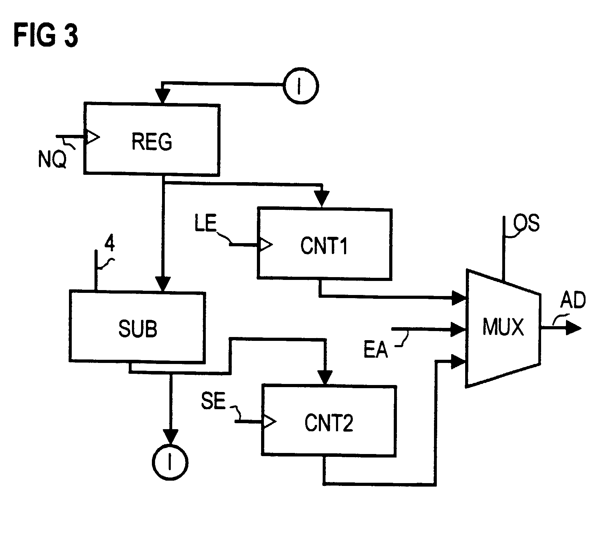

Die Einheit zur Adressierung, die in der Speichersteuereinrichtung CON der Speichereinheit SP enthalten ist, ist gemäß Figur 3 aufgebaut. Der Ausgang eines parallel ladbaren Registers REG ist mit einem Eingang eines Subtrahierers SUB und einem Eingang eines ersten ladbaren Zählers CNT1 gekoppelt. Der Ausgang des ersten Zählers CNT1 ist zu einem Eingang eines 3:1 Multiplexers MUX geführt. Der Ausgang des Subtrahierers SUB ist mit dem Eingang des Registers REG und dem Eingang eines zweiten ladbaren Zählers CNT2 gekoppelt. Der Ausgang des zweiten Zählers CNT2 ist mit einem weiteren Eingang des Multiplexers MUX gekoppelt. An einem dritten Eingang des Multiplexers MUX ist für Testzwecke eine externe Adresse EA anlegbar. Mit Hilfe eines an einer Auswahlleitung OS des Multiplexers MUX anliegenden Signals ist eine der drei an dessen Eingängen vorliegenden Adressen AD auswählbar. Diese wird zur Adressierung des Speichers RAM verwendet.

Der erste ladbare Zähler CNT1 bestimmt die Leseadresse. Ist eine Adressierung mittels eines ersten Zählerstandes dieses Zählers CNT1 erfolgt, dann wird dieser Zählerstand durch ein Signal LE um 1 inkrementiert. Der zweite ladbare Zähler CNT2 bestimmt die Schreibadresse. Ist eine Adressierung mittels eines ersten Zählerstandes dieses Zählers CNT2 erfolgt, dann wird dieser Zählerstand durch ein Signal SE um 1 inkrementiert. Durch den Subtrahierer SUB ist der Zählerstand des ersten Zählers CNT1 nach dem Laden durch das Register REG um 4 höher als der Zählerstand des zweiten Zählers CNT2 nach dem Laden durch den Subtrahierer SUB.

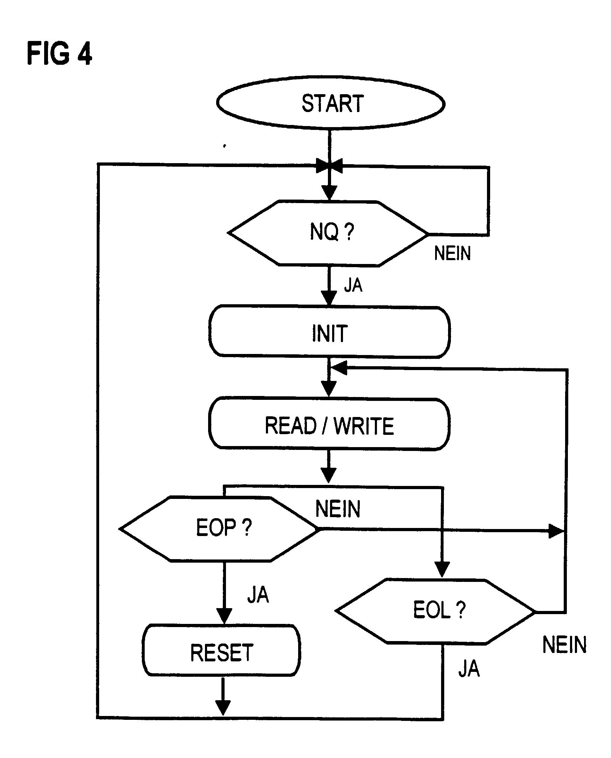

Der Speicher RAM wird durch die Verfahrensschritte gemäß den Figuren 4 bis 7 gesteuert. Die Speichersteuereinrichtung CON erhält zu Beginn einer neuen Zeile ein Signal NQ von der Steuerungslogik CL. Die Speichersteuereinrichtung CON erkennt das Signal NQ und startet das Unterprogramm INIT zur Initialisierung der Speichereinrichtung SP.

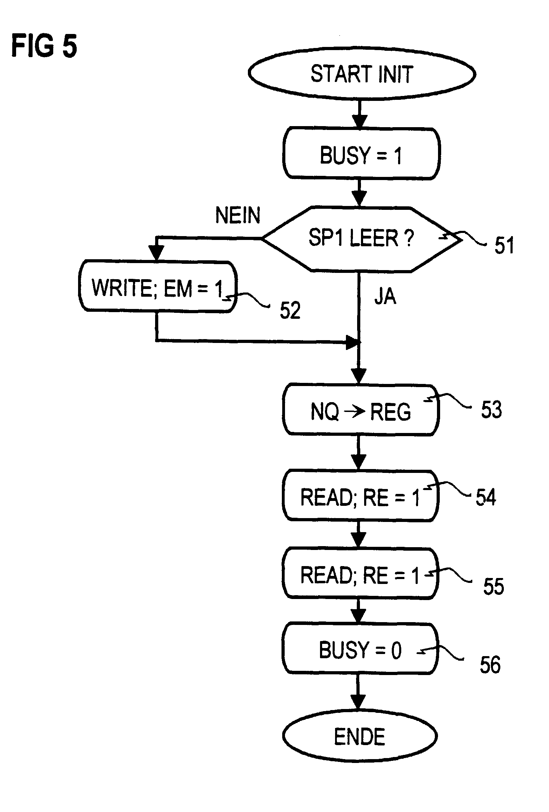

Dieses Unterprogramm INIT zur Initialisierung der Speichereinrichtung SP ist in Figur 5 dargestellt. Nach seinem Aufruf setzt dieses Unterprogramm eine Variable BUSY=1, wodurch der Steuerungslogik CL signalisiert wird, daß ein Speicherzugriff derzeit nicht möglich ist. Anschließend überprüft das Unterprogramm INIT in einem ersten Schritt 51, ob der Serien- /Parallelwandler SP1 leer ist. Sind im Serien-/Parallelwandler noch Pixel enthalten, wird in einem zweiten Schritt 52 ein Unterprogramm WRITE zur Übernahme der Pixel aus dem Serien- /Parallelwandler SP1 in den Speicher RAM gestartet. Dazu wird eine Variable EM = 1 gesetzt.

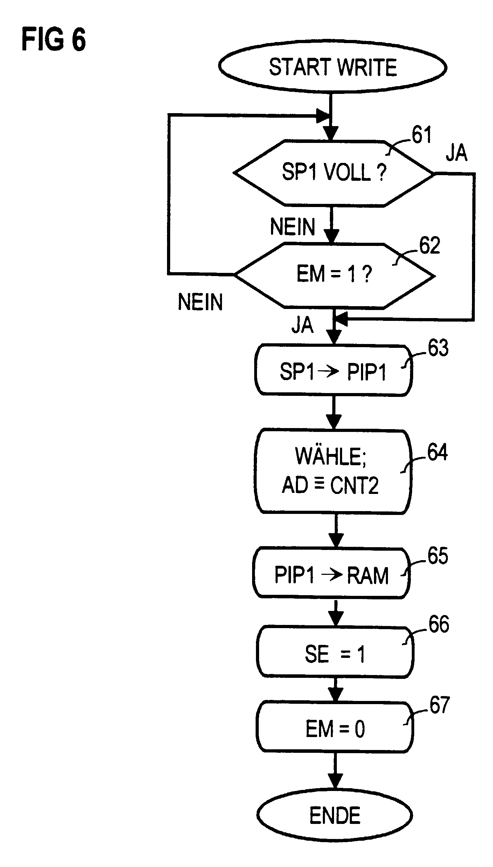

Das Unterprogramm WRITE ist in Figur 6 dargestellt. Es überwacht in einem ersten Schritt 61 ständig, ob der Serien-/Parallelwandler SP1 mit Pixelinformationen gefüllt ist. In einem zweiten Schritt wird überwacht, ob das Unterprogramm INIT die Schreibvariable EM auf den Wert 1 gesetzt hat. Ist mindestens eine der beiden Bedingungen erfüllt, veranlaßt das Unterprogramm WRITE mittels der Speichersteuereinrichtung CON in einem dritten Schritt 63 die Übernahme der Pixel aus dem Serien- /Parallelwandler SP1 in die erste Pufferstufe PIP1. In einem vierten Schritt 64 erhält der Multiplexer MUX der Speichersteuereinrichtung gemäß Figur 3 über seine Auswahlleitung OS eine Information, auf Grund derer zu seinem Ausgang AD der Zählerstand des zweiten ladbaren Zählers CNT2 durchgeschaltet wird. Zum durch diese Adresse AD bestimmten Speicherbereich des Speichers RAM wird in einem fünften Schritt 65 die Pixelinformation aus dem ersten Pufferspeicher PIP1 transferiert und gespeichert. In einem sechsten Schritt 66 erzeugt die Speichersteuereinrichtung CON ein Signal SE, mit dem der zweite ladbare Zähler CNT2 um eins inkrementiert wird. Dadurch wird sichergestellt, daß die nächste Pixelinformation in den unmittelbar nachfolgenden Speicherbereich geschrieben wird. In einem siebten Schritt 67 wird die Variable EM = 0 gesetzt und das Unterprogramm WRITE beendet.

Das Unterprogramm INIT zur Initialisierung gemäß Figur 5 wird mit einem dritten Schritt 53 fortgesetzt. Bei diesem Schritt wird die Speichersteuereinrichtung CON durch ein zum Register REG geführtes Signal NQ umgeschaltet. Infolgedessen erfolgt ein erster Ladevorgang LA1. Dabei wird der erste ladbare Zähler CNT1 mit dem Inhalt des Registers REG geladen. Gleichzeitig wird der zweite ladbare Zähler CNT2 mit dem durch den Subtrahierer SUB um vier verringerten Inhalt des Registers REG geladen. Der Ausgang des Subtrahierers SUB ist auch an den Eingang des Registers REG geführt, wodurch das Register REG mit seinem um vier verringerten Wert neu geladen wird. Durch diese Maßnahme beginnt der Schreibvorgang immer bei einer Adresse, die um vier kleiner, als die Leseadresse ist. Beim nächsten Ladevorgang LA2 der Zähler CNT1, CNT2 erhält der erste Zähler CNT1 wieder den Inhalt des Registers REG, der dem vorhergehenden Startwert des zweiten Zählers CNT2 entspricht. Zu Beginn jeder Rasterzeile wird also dort mit dem Lesen begonnen, wo eine Rasterzeile vorher mit dem Schreiben begonnen wurde. Es wird ein Abstand von vier Adressen eingehalten. Bei einer Speicherbreite von einem Byte ergibt sich ein Abstand von 4 * 8 = 32 Pixeln zwischen dem Lesen der Referenzzeile und dem Schreiben der aktuellen Zeile. Nachfolgende Tabelle verdeutlicht dies.

| | RESET | LA1 | LA2 | LA3 |
|---|---|---|---|---|
| REG | 0 | -4 | -8 | -12 |
| CNT1 | 0 | 0 | -4 | -8 |
| CNT2 | 0 | -4 | -8 | -12 |

Ausgehend von einem Grundzustand, bei dem sämtliche Zähler CNT1, CNT2 und Register REG auf Null gesetzt sind, wird beim ersten Ladevorgang LA1 der erste ladbare Zähler CNT1 auf den Wert Null gesetzt. Der zweite ladbare Zähler CNT2 wird auf den Startwert -4 gesetzt und das Register REG wird mit dem Wert -4 geladen. Beim zweiten Ladevorgang LA2 wird der erste ladbare Zähler CNT1 mit dem Registerinhalt -4 geladen, und der zweite ladbare Zähler CNT2 mit dem um vier verminderten Registerwert -8. Der Wert -8 wird wiederum in das Register REG eingetragen. Beim dritten Ladevorgang LA3 wird entsprechend der erste ladbare Zähler CNT1 mit dem Wert -8 geladen und der zweite ladbare Zähler CNT2 mit dem um vier verminderten Wert -12. Dieser Wert -12 wird auch in das Register REG übernommen, so daß bei den nachfolgenden Ladevorgängen die beschriebenen Vorgänge weitergeführt werden können.

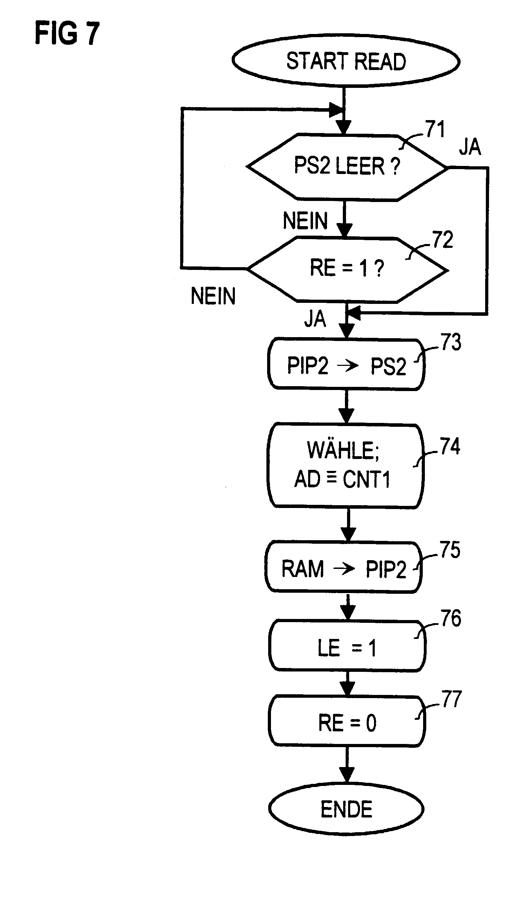

In einem vierten Schritt 54, startet das Unterprogramm INIT zur Initialisierung ein Unterprogramm READ zum Lesen von Pixeln aus dem Speicher RAM. Ein Ablaufdiagramm dieses Unterprogramms ist in Figur 7 dargestellt. In einem ersten Schritt 71 überprüft das Unterprogramm READ ständig, ob der Parallel/Serienwandler PS2 leer ist. In einem zweiten Schritt 72 wird überprüft, ob eine Lesevariable RE auf den Wert 1 gesetzt ist. Dieses Setzen der Lesevariablen RE wird im vierten Schritt 54 des Unterprogramms INIT vorgenommen. Ist eine der Bedingungen der ersten beiden Schritte 71, 72 erfüllt, dann werden in einem dritten Schritt 73 die Pixel aus dem zweiten Pufferspeicher PEP2 in den Parallel- /Serienwandler PS2 übernommen. In einem vierten Schritt 74 wird mit Hilfe der Auswahlleitung OS des Multiplexers MUX der Speichersteuereinrichtung CON als Adresse AD der Zählerstand des ersten Zählers CNT1 ausgewählt. Mit dieser Adresse AD wird der Speicher RAM adressiert. Im nachfolgenden fünften Schritt 75 wird der entsprechende Speicherinhalt des Speichers RAM in den zweiten Pufferspeicher PIP2 übertragen. Im nachfolgenden sechsten Schritt 76 wird der erste ladbare Zähler CNT1 durch das Signal LE inkrementiert. Mit dem siebten Schritt 77 wird die Lesevariable RE zurückgesetzt. Damit wird mit dem Unterprogramm zum Lesen der Pixel der Inhalt des zweiten Pufferspeichers PEP2 in den Parallel- /Serienwandler PS2 übertragen, der zweite Pufferspeicher PEP2 mit den als nächste benötigten Pixeln aus dem Speicher RAM geladen und der erste ladbare Zähler CNT1 zur Adressierung des nächsten auszulesenden Byte von Pixeln aus dem Speicher RAM eingestellt.

Das Unterprogramm zur Initialisierung INIT wird mit einem fünften Schritt 55, bei dem die Lesevariable RE wiederum gesetzt wird, fortgesetzt. Durch das nochmalige Abarbeiten des Unterprogramms READ zum Lesen der Pixel, werden die ersten acht Pixel einer neuen Zeile in den Parallel- /Serienwandler PS2 übertragen. Die zweiten acht Pixel der neuen Zeile gelangen in den zweiten Pufferspeicher PIP2 und die Adresse der dritten benötigten acht Pixel der neuen Zeile wird im ersten ladbaren Zähler CNT1 eingestellt. In einem sechsten Schritt 56 wird das Wartesignal BUSY zurückgesetzt und das Unterprogramm INIT zur Initialisierung beendet.

Nachfolgend werden von der Steuerungslogik CL Pixel der Referenzzeile aus der Speichereinrichtung SP bitweise ausgelesen und Pixel der aktuellen Zeile bitweise in die Speichereinrichtung SP geschrieben. Eine Adressierung von Außen erfolgt nicht, da durch die beschriebene Speichereinrichtung sichergestellt ist, daß die in einer bestimmten Reihenfolge in die Speichereinrichtung SP geschriebenen Pixel auch in der selben Reihenfolge von dieser wieder ausgegeben werden. Die Unterprogramme READ und WRITE der Speichersteuereinrichtung CON der Speichereinrichtung SP sorgen dafür, daß stets Pixel in den Serien- /Parallelwandler SP1 schreibbar und Pixel aus dem Parallel- /Serienwandler PS2 auslesbar sind. Die Überwachung, ob der Serien- /Parallelwandler SP1 voll bzw. der Parallel/Serienwandler PS2 leer ist, wird durch spezielle den Wandlern SP1, PS2 zugeordnete Zähler vorgenommen.

Während der Schreib- und Lesezugriffe auf die Speichereinrichtung SP, überwacht die Steuerungslogik CL gemäß Figur 4 ständig, ob ein Zeilenende EOL oder ein Seitenende EOP erreicht ist. Ein Zeilenende EOL führt, wie oben beschrieben, zur Initialisierung der Speichereinrichtung SP. Ein Seitenende EOP führt zur Generierung eines Rücksetzsignals RESET, das der Speichereinrichtung SP zugeleitet wird. Auf Grund dieses Rücksetzsignals RESET werden die Register- und Speicherinhalte der Speichereinrichtung SP auf den Wert Null gesetzt. Anschließend kann mit der Dekomprimierung einer neuen Seite begonnen werden.

Die Speichereinrichtung SP dient damit dem sequentiellen Speichern und Auslesen einer bestimmten Datenmenge. Sie enthält dazu einen parallel lesbaren und beschreibbaren Speicher RAM und eine Speichersteuereinrichtung CON. Letztere sorgt dafür, daß unter Vorgabe eines Sicherheitsabstandes Speicherbereiche sequentiell nacheinander beschrieben werden, deren Daten vorher wenigstens einmal ausgelesen wurden. In der speziellen Ausgestaltung sind dem Speicher RAM eine Eingangsschnittstelle SPU vor- und eine Ausgangsschnittstelle PSU nachgeschaltet. Diese übernehmen bzw. übergeben die Daten nach außen seriell und zum Speicher RAM hin parallel.

## Patentansprüche

1. Speichereinrichtung zum gleichzeitigen Lesen- und Schreiben von Daten, mit einem Speicher (RAM), bei dem Daten wortsequentiell einschreibbar und wortsequentiell auslesbar sind und mit einer eine erste und eine zweite Adressiereinrichtung (CNT1, CNT2) enthaltenden Speichersteuereinrichtung (CON),
dadurch **gekennzeichnet**,
- daß die Speichersteuereinrichtung ein auf einen vordefinierten Wert setzbares Register (REG) enthält, dem ein einen vorgebbaren Betrag vom aktuellen Wert des Registers (REG) abziehender Subtrahierer (SUB) nachgeschaltet ist,
- wobei der Ausgang des Registers (REG) mit Eingängen zum Schreiben einer Leseadresse in einen ersten inkrementierbaren und ladbaren Speicher (CNT1) und den Eingängen des Subtrahierers (SUB) gekoppelt ist,
- der Ausgang des Subtrahierers (SUB) mit Eingängen zum Schreiben einer Schreibadresse in einen zweiten inkrementierbaren und ladbaren Speicher (CNT2) und den Eingängen des Registers (REG) gekoppelt ist,
- die inkrementierbaren Speicher (CNT1, CNT2) jeweils mittels einer Steuerleitung (LE, SE) getrennt voneinander inkrementierbar sind,
- eine steuerbare Auswahleinrichtung (MUX) bestimmt, welcher der Inhalte der inkrementierbaren Speicher (CNT1, CNT2) als Speicheradressierung zu verwenden ist,
- und wobei die Inkrementierung so erfolgt, daß beim Speichern und Auslesen die Daten im Speicher (RAM) erst dann überschrieben werden, wenn sie mindestens einmal ausgelesen worden sind.

2. Speichereinrichtung nach Anspruch 1, **gekennzeichnet** durch
- eine Eingangsschnittstelle (SPU), die Daten seriell aufnimmt und parallel an den Speicher (RAM) abgibt, und
- eine Ausgangsschnittstelle (PSU), die Daten aus dem Speicher (RAM) parallel aufnimmt und seriell abgibt.

3. Speichereinrichtung nach Anspruch 2, **gekennzeichnet** durch
- eine Eingangsschnittstelle (SPU), die einen Serien/Parallelwandler (SP1) und einen ersten die Daten aus dem Serien-/Parallelwandler (SP1) aufnehmenden und an den Speicher (RAM) abgebenden Pufferspeicher (PIP1) enthält, und
- eine Ausgangsschnittstelle (PSU), die einen Parallel/Serienwandler (PS2) und einen zweiten, die Daten aus dem Speicher (RAM) aufnehmenden und an den Parallel/Serienwandler (SP2) abgebenden Pufferspeicher (PIP2) enthält.

4. Speichereinrichtung nach einem der Ansprüche 1 bis 3, dadurch **gekennzeichnet**, daß das Register (EG) bei Ansteuerung durch einen entsprechenden Impuls (NQ) Daten aus dem Subtrahierer (SUB) übernimmt.

5. Speichereinrichtung nach einem der Ansprüche 1 bis 4, dadurch **gekennzeichnet**, daß die inkrementierbaren Speicher (CNT1, CNT2) als ladbare Zähler ausgebildet sind.

6. Verfahren zum gleichzeitigen Lesen und Schreiben von Daten, mit einem Speicher (RAM), in den Daten wortsequentiell einschreibbar und wortsequentiell auslesbar sind und der mittels einer eine erste und eine zweite Adressiereinrichtung (CNT1, CNT2) enthaltenden Speichersteuereinrichtung (CON) steuerbar ist, **gekennzeichnet** durch folgende Schritte:
- Setzen eines Registers (REG), auf einen vordefinierten Wert,
- Übernahme des vordefinierten Wertes in einen ersten inkrementierbaren Speicher (CNT1) und in einen Subtrahierer (SUB),
- Übernahme des durch den Subtrahierer (SUB) um einen vordefinierten Betrag verminderten vordefinierten Wertes in einen zweiten inkrementierbaren Speicher (CNT2),
- Auslesen und Beschreiben des Speichers (RAM) mittels wiederholtem
- Adressieren des Speichers (RAM) mit dem Inhalt des ersten Speichers (CNT1),
- Lesen von Daten aus dem gemäß Inhalt des ersten Speichers (CNT1) ausgewählten Speicherbereich des Speichers (RAM),
- Inkrementieren des ersten Speichers (CNT1),
- Adressieren des Speichers (RAM) mit dem Inhalt des zweiten Speichers (CNT2),
- Schreiben von Daten in den gemäß Inhalt des zweiten Speichers (CNT2) ausgewählten Speicherbereich des Speichers (RAM), wobei Daten erst dann überschrieben werden, wenn sie mindestens einmal gelesen worden sind,
- Inkrementieren des zweiten Speichers (CNT2),
- wobei seriell ankommende Daten von einer Eingangsschnittstelle (SPU) aufgenommen und gleichzeitig Daten seriell von einer Ausgangsschnittstelle (PSU) abgegeben werden.

7. Verfahren nach Anspruch 6, dadurch **gekennzeichnet**,
- daß die seriell ankommenden Daten von der Eingangsschnittstelle (SPU) aufgenommen werden und parallel in den jeweils ausgewählten Speicherbereich des Speichers (RAM) eingeschrieben werden, und
- daß Daten parallel aus dem jeweils ausgewählten Speicherbereich des Speichers (RAM) ausgelesen und and die Ausgangsschnittstelle (PSU) übergeben werden, die die Daten seriell abgibt.

## Claims

1. Storage device for the simultaneous reading and writing of data, having a memory (RAM), to which data can be written in a word-sequential manner and from which data can be read in a word-sequential manner, and having a memory control device (CON) containing a first and a second addressing device (CNT1, CNT2),
characterized
- in that the memory control device contains a register (REG), which can be set to a predefined value and downstream of which is connected a subtractor (SUB), which subtracts a predeterminable magnitude from the current value of the register (REG),
- the output of the register (REG) being coupled to inputs for writing a read address to a first incrementable and loadable store (CNT1), and being coupled to the inputs of the subtractor (SUB),
- the output of the subtractor (SUB) being coupled to inputs for writing a write address to a second incrementable and loadable store (CNT2), and being coupled to the inputs of the register (REG),
- the incrementable stores (CNT1, CNT2) being incrementable separately from one another by means of a respective control line (LE, SE),
- a controllable selection device (MUX) determining which of the contents of the incrementable stores (CNT1, CNT2) is to be used as memory addressing,
- and the incrementing being effected in such a way that in the event of storage and read-out, the data in the memory (RAM) are overwritten only when they have been read out at least once.

2. Storage device according to Claim 1, characterized by
- an input interface (SPU), which receives data serially and outputs them in parallel to the memory (RAM), and
- an output interface (PSU), which receives data in parallel from the memory (RAM) and outputs them serially.

3. Storage device according to Claim 2, characterized by
- an input interface (SPU) which contains a serial/parallel converter (SP1) and a first buffer store (PIP1), which receives the data from the serial/parallel converter (SP1) and outputs them to the memory (RAM), and
- an output interface (PSU) which contains a parallel/serial converter (PS2) and a second buffer store (PIP2), which receives the data from the memory (RAM) and outputs them to the parallel/serial converter (PS2).

4. Storage device according to one of Claims 1 to 3, characterized in that in the event of driving by a corresponding pulse (NQ), the register (REG) accepts data from the subtractor (SUB).

5. Storage device according to one of Claims 1 to 4, characterized in that the incrementable stores (CNT1, CNT2) are designed as loadable counters.

6. Method for the simultaneous reading and writing of data, with a memory (RAM), to which data can be written in a word-sequential manner and from which data can be read in a word-sequential manner, and which can be controlled by means of a memory control device (CON) containing a first and a second addressing device (CNT1, CNT2), characterized by the following steps:
- setting of a register (REG) to a predefined value,
- acceptance of the predefined value into a first incrementable store (CNT1) and into a subtractor (SUB),
- acceptance of the predefined value, reduced by a predefined magnitude by the subtractor (SUB), into a second incrementable store (CNT2),
- reading from and writing to the memory (RAM) by means of repeated
- addressing of the memory (RAM) with the content of the first store (CNT1),
- reading of data from the memory area of the memory (RAM) which is selected in accordance with the content of the first store (CNT1),
- incrementing of the first store (CNT1),
- addressing of the memory (RAM) with the content of the second store (CNT2),
- writing of data to the memory area of the memory (RAM) which is selected in accordance with the content of the second store (CNT2), data being overwritten only when they have been read at least once,
- incrementing of the second store (CNT2),
- serially incoming data being received by an input interface (SPU) and, at the same time, data being serially output by an output interface (PSU).

7. Method according to Claim 6, characterized
- in that the serially incoming data are received by the input interface (SPU) and are written in parallel to the respectively selected memory area of the memory (RAM), and
- in that data are read in parallel from the respectively selected memory area of the memory (RAM) and are transferred to the output interface (PSU) which serially outputs the data.

## Revendications

1. Dispositif de mémorisation pour lire et écrire simultanément des données, comprenant une mémoire (RAM), dans laquelle des données peuvent être inscrites en séquences de mots et lues en séquences de mots, et un dispositif de commande de mémorisation (CON) contenant un premier et un deuxième dispositifs d'adressage (CNT1, CNT2),
caractérisé en ce que :
- le dispositif de commande de mémorisation comprend un registre (REG) pouvant être mis à une valeur prédéfinie, en aval duquel est connecté un soustracteur (SUB) qui déduit de la valeur actuelle du registre (REG) un montant pouvant être prédéterminé :
- la sortie du registre (REG) est couplée à des entrées servant à écrire une adresse de lecture dans une première mémoire incrémentable chargeable ((CNT1), et aux entrées du soustracteur (SUB),
- la sortie du soustracteur (SUB) est couplée à des entrées pour écrire une adresse d'écriture dans une deuxième mémoire incrémentable et chargeable (CNT2), et aux entrées du registre (REG),
- les mémoires incrémentables (CNT1, CNT2) peuvent être incrémentées séparément l'une de l'autre, chacune au moyen d'une ligne de commande (LE, SE),
- un dispositif de sélection commandé (MUX) détermine celui des contenus des mémoires incrémentables (CNT1, CNT2) qui doit être utilisé comme adressage de mémoire,
- et l'incrémentation s'effectue de manière que, lors de la mémorisation et de la lecture, les données contenues dans la mémoire (RAM) ne soient transcrites pour écrasement que lorsqu'elles ont été lues au moins une fois.

2. Dispositif de mémorisation selon la revendication 1, caractérisé par :
- une interface d'entrée (SPU) qui reçoit les données en série et les transmet à la mémoire (RAM) en parallèle, et
- une interface de sortie (PSU) qui reçoit en parallèle les données provenant de la mémoire (RAM) et les transmet en série.

3. Dispositif de mémorisation selon la revendication 2, caractérisé par :
- une interface d'entrée (SPU) qui renferme un convertisseur série-parallèle (SPI) et une première mémoire tampon (PIP1) qui reçoit les données provenant du convertisseur série/parallèle (SP1) et les transmet à la mémoire (RAM), et
- une interface de sortie (PSU) qui renferme un convertisseur serie/parallèle (SP2) et une deuxième mémoire tampon (PIP2) qui reçoit les données en provenance de la mémoire (RAM) et les transmet au convertisseur serie/parallèle (SP2).

4. Dispositif de mémorisation selon une des revendications 1 à 3, caractérisé en ce que le registre (REG) prend en charge des données provenant du soustracteur (SUB) lorsqu'il est commandé par une impulsion correspondante (NQ).

5. Dispositif de mémorisation selon une des revendications 1 à 4, caractérisé en ce que les mémoires incrémentables (CNT1, CNT2) sont constituées par des compteurs chargeables.

6. Procédé pour lire et écrire simultanément des données, avec une mémoire (RAM) dans laquelle des données peuvent être inscrites en séquences de mots et lues en séquences de mots et qui peut être commandée au moyen d'un dispositif de commande de mémorisation (CON) contenant un premier et un deuxième dispositifs d'adressage (CNT1, CNT2), caractérisé par les phases suivantes :
- mise d'un registre (REG) à une valeur prédéfinie,
- prise en charge de la valeur prédéfinie dans une première mémoire incrémentable (CNT1) et dans un soustracteur (SUB),
- prise en charge de la valeur prédéfinie, diminuée d'un montant prédéfini par le soustracteur (SUB), dans une deuxième mémoire incrémentable (CNT2),
- lecture et inscription de la mémoire (RAM) selon les opérations répétées suivantes :
- adressage de la mémoire (RAM) avec le contenu de la première mémoire (CNT1),
- lecture de données issues de la région de la mémoire (RAM) qui est sélectionnée en fonction du contenu de la première mémoire (CNT1),
- incrémentation de la première mémoire (CNT1),
- adressage de la mémoire (RAM) avec le contenu de la deuxième mémoire (CNT2),
- inscription de données dans la région de la mémoire (RAM) qui est sélectionnée en fonction du contenu de la deuxième mémoire (CNT)2), ces données n'étant transcrites pour écrasement que lorsqu'elles ont été lues au moins une fois,
- incrémentation de la deuxième mémoire (CNT2),
- des données arrivant en série étant reçues par une interface d'entrée (SPU) et des données étant en même temps transmises en série par une interface de sortie (PSU).

7. Procédé selon la revendication 6, caractérisé en ce que :
- les données arrivant en série sont reçues par l'interface d'entrée (SPU) et inscrites en parallèle dans la région sélectionnée de la mémoire (RAM), et
- des données sont lues en parallèle dans la région sélectionnée de la mémoire (RAM) et transférées à l'interface de sortie (PSU) qui transmet les données en série.
